# EUROPEAN PATENT SPECIFICATION

(11) **EP 3 458 629 B1**
(45) Date of publication and mention of the grant of the patent: **18.10.2023**
(21) Application number: 17724927.3
(22) Date of filing: 10.05.2017
(51) Int. Cl.: C30B 11/00, C30B 35/00, C30B 29/06

(54) **SILICON INGOT GROWTH CRUCIBLE WITH PATTERNED PROTRUSION STRUCTURED LAYER**
SILICIUMSTABWACHSTUMSTIEGEL MIT STRUKTURIERTER SCHICHT MIT GEMUSTERTER PROTRUSION
CREUSET DE CROISSANCE DE LINGOTS DE SILICIUM À COUCHE STRUCTURÉE DE SAILLIES À MOTIF

(30) Priority: 18.05.2016 GB 201608873
(43) Date of publication of application: 27.03.2019
(73) Proprietor: REC Solar Pte. Ltd., Singapore 637312 (SG)
(72) Inventor: KUMARAN, Abbu Udaiyar Senthil, Singapore 600321 (SG); WU, YuHao, Mike, Singapore 648305 (SG); TANG, Qi, Singapore 668201 (SG); LE FLAO, Benoit Jean Jacques, Singapore 768098 (SG); NG, Hock Kar, Singapore 510776 (SG); SONG, Adolphus, Singapore 538755 (SG)
(74) Representative: Mewburn Ellis LLP
(86) International application number: PCT/IB2017/052720
(87) International publication number: WO 2017/199132

(56) References cited:
- EP-A2- 0 949 358
- WO-A1-2005/106084
- CN-A- 103 088 417
- CN-A- 105 063 748
- DE-A1-102010 000 687
- US-A1- 2013 008 371

## Description

### FIELD OF THE INVENTION

The present invention relates to a crucible for growing silicon crystal ingots which can be used e.g. for producing multi-crystalline silicon wafers for solar cell fabrication. The invention also relates to a method for preparing a crucible.

### TECHNICAL BACKGROUND

Solar cells are photovoltaic devices for converting light energy into electric energy. Solar cells are generally based on a semiconductor substrate. Most commercially available solar cells are produced using a silicon substrate such as a silicon wafer.

Silicon wafers are generally produced by slicing or sawing thin slices from a solid silicon block. Such silicon block is generally made by melting purified silicon and then solidifying the melt. Depending on physical conditions, such solidifying may result in a mono-crystalline silicon block or a multi-crystalline (mc-Si) or poly-crystalline silicon block.

Multi-crystalline silicon is produced in many cases by filling or casting a liquid silicon melt into a specific crucible and then solidifying the melt by cooling it down in a specifically controlled manner. Generally, physical conditions during such solidification process may significantly influence physical characteristics of the resulting crystalline silicon block. Such crystalline silicon block is also referred to as silicon ingot.

Conventionally, crucibles used for growing silicon ingots comprise a vessel made from a highly temperature-resistant material such as silica (also referred to as quartz crucible), graphite, silicon carbide or similar. In many cases, surfaces of this vessel are coated with additional layers serving for example as barriers for preventing any contaminants diffusing from the vessel into the very hot silicon melt. Coated layers are also provided for simplifying a release of the ingot from the crucible after solidification.

DE102010000687 discloses a crucible for the preparation of silicon, the crucible having a bottom wall and side walls, the bottom wall comprising seed particles of a material having a higher melting point than silicon. EP99103701 discloses a mold for producing a silicon ingot having a layered structure comprising an inner silica layer containing at least one layer in which a fused silica powder with a particle size of 100 µm or less and a fine fused silica sand with a particle size of 100 to 300 µm is bonded with a silica binder, and an outer silica layer containing at least one layer in which a fused silica powder with a particle size of 100 µm or less and a coarse fused silica sand with a particle size of 500 to 1500 µm is bonded with a silica binder. WO2005106084 discloses a crucible for the crystallization of silicon comprising a base body comprising a bottom surface and side walls defining an inner volume; an intermediate layer comprising 50 to 100 wt. % of silica at the surface of the side walls facing the inner volume; and a surface layer comprising 50 to 100 wt. % of silicon nitride, up to 50 wt. % of silicon dioxide and up to 20 wt. % of silicon on the top of the intermediate layer. CN105063748 discloses a quartz crucible, wherein the inner side of the crucible is set with a silicon nitride composite layer, and particles are embedded into the silicon nitride composite layer, the particles having a diameter of 5-15 mm.

### SUMMARY OF THE INVENTION

There may be a need for an improved crucible for growing silicon ingots enabling, inter alia, producing ingots having advantageous physical characteristics. Particularly, there may be a need for an improved crucible with which silicon ingots may be casted based on which silicon wafers for highly efficient solar cells may be produced. Furthermore, there may be a need for an advantageous method for preparing such crucible.

Such needs may be met with the crucible and the method according to the independent claims, which define the present invention. Advantageous embodiments are defined in the dependent claims and in the specification.

According to a first aspect of the present invention, a crucible for growing silicon ingots is proposed. The crucible comprises a vessel having a bottom wall and side walls surrounding an inner portion of the vessel. The crucible further comprises a coating layer applied to inner surfaces of the bottom wall and of the side walls. This coating layer comprises a temperature-resistant material compatible with ingot growth from molten silicon such as for example silicon nitride. The crucible further comprises a patterned protrusion layer applied at the inner surface of the bottom wall. The patterned protrusion layer comprises a matrix consisting of silicon nitride as a temperature-resistant material compatible with ingot growth from molten silicon. The patterned protrusion layer furthermore comprises particles of a nucleation enhancing material being one of Silica (SiO₂) sand, Silicon Carbide (SiC) and Carbon (C), which is adapted for forming a wetting agent when in contact with a liquid silicon melt, these particles locally protruding from the matrix of the patterned protrusion layer. The particles of the nucleation enhancing material have sizes of between 100 µm and 1 mm.

According to a second aspect of the present invention, a method of preparing a crucible for growing silicon ingots is proposed. The method comprises at least the following steps, preferably in the indicated order: First, a vessel having a bottom wall and side walls surrounding an inner portion of the vessel is provided. Then, a coating layer is applied to inner surfaces of the bottom wall and the side walls. This coating layer comprises a temperature-resistant material compatible with ingot growth from molten silicon such as for example silicon nitride. A temperature-resistant material should be resistant to temperatures up to at least 1000°C, preferably at least 1400°C or even at least 1500°C, without being significantly damaged or deteriorated. Subsequently, a patterned protrusion layer is applied to the inner surface of the bottom wall, i.e. on top of the coating layer previously applied to this bottom wall. The patterned protrusion layer comprises a matrix consisting of silicon nitride as a temperature-resistant material compatible with ingot growth from molten silicon. Furthermore, the patterned protrusion layer comprises particles of a nucleation enhancing material being one of Silica (SiO₂) sand, Silicon Carbide (SiC) and Carbon (C), which is adapted for forming a wetting agent when in contact with a liquid silicon melt. Therein, the patterned protrusion layer is applied in such manner and the particles are adapted such that the particles locally protrude from the matrix. The particles of the nucleation enhancing material have sizes of between 100 µm and 1 mm.

Principles relating to embodiments of the present invention may be understood as being based, inter alia and without restricting a scope of the invention, on the following ideas and recognitions:
As indicated in the introductory portion, it has been found that coating walls of a vessel of a crucible with a temperature-resistant material may be beneficial for various reasons. Inter alia, the coating layer may prevent contaminants from diffusing from the vessel into a hot silicon melt casted into the crucible. Furthermore, the coating layer may serve as a release layer simplifying a release of the solidified silicon ingot from the crucible. For such purpose, the coating layer is typically made such as to form a non-wetting agent when in contact with the liquid silicon melt. For example, a coating comprising silicon nitride, for example in a form of a silicon nitride powder, has been proven to provide good protection and releasing characteristics for the vessel of the crucible. Accordingly, all inner surfaces of the walls of the vessel, i.e. surfaces directing to the inner portion of the vessel and therefore coming into contact with a hot silicon melt casted into the vessel, are preferably coated with the coating layer.

However, it has been found that silicon ingots casted in such coated vessels may have a nonoptimum characteristics when used for slicing silicon wafers for silicon solar cell fabrication.

Surprisingly, it has now been found that providing an inner surface of the bottom wall of the vessel with a patterned protrusion layer applied thereon may influence characteristics of the resulting silicon ingot in a positive manner. I.e. solar cells produced on wafers sliced from such silicon ingot may have an increased efficiency. Particularly, it is assumed that the patterned protrusion layer may alter a surface morphology, e.g. increase a roughness, at the inner surface of the vessel. Furthermore, the patterned protrusion layer may create local temperature non-uniformities when a vertical temperature gradient is high. Additionally, the patterned protrusion layer may include randomly distributed nucleation enhancing particles on the matrix which may act as wetting points, thereby altering or improving wetting properties to help the silicon to nucleate.

The coating layer may be deposited directly on top of one or more walls of the crucible. The patterned protrusion layer may be deposited directly on top of the underlying coating layer, i.e. may be in direct mechanical contact with the coating layer. Alternatively, additional layers having suitable temperature-resistance may be interposed between the patterned protrusion layer and the coating layer and/or between the coating layer and a wall of the crucible.

Specifically, the patterned protrusion layer comprises a matrix which may be made of a same or a similar temperature-resistant material as the material of the underlying coating layer.

The matrix consists of silicon nitride. Similarly as for the coating layer, such material of the matrix may act as an ingot releasing agent. In this context, a "temperature-resistant material compatible with ingot growth from molten silicon" may be understood as a material which does not significantly permanently change its physical and/or chemical characteristics upon being subjected to temperatures as they typically occur during ingot growth from a silicon melt, i.e. temperatures of typically above 1000°C or in many times above 1500°C. Particularly, such temperature-resistant material shall not melt or burn at the mentioned temperatures. The matrix of the patterned protrusion layer may form a layer or film. Into this matrix, small particles of nucleation enhancing material are included. Therein, characteristics of the matrix as well as of the particles are adapted such that the particles locally protrude from the matrix. In other words, for example a thickness with which the matrix layer is applied onto the inner surface of the bottom wall may be in a same order of magnitude or may be smaller than dimensions of at least many of the particles embedded in the matrix such that at least these particles are not completely enclosed in the matrix but protrude from the matrix towards the inner portion of the vessel. In other words, the protruding particles form small or even microscopic protrusions extending from the inner surface of the bottom wall towards the inner portion of the vessel. The protrusions may form a regular or an irregular, e.g. random, pattern.

These protruding particles are made from a nucleation enhancing material. This means that the particles are generally made with a material different from the material of the matrix and having other physical characteristics. Accordingly, due to such differing physical characteristics, each of the protruding particles may serve as a nucleation point upon solidifying the silicon melt within the crucible. In other words, upon cooling down the silicon melt within the crucible, solidification processes will preferably start at one of such nucleation points.

It has been observed that providing a large number of nucleation points upon solidifying a silicon melt may result in smaller crystal grains in the resulting silicon ingot. The presence of such smaller grains in the ingot may in consequence reduce a dislocation density defect propagation towards a top of the ingot. As a result thereof, physical characteristics of wafers sliced from such ingot may the enhanced and a conversion efficiency of a solar cell fabricated with such wafer may be improved.

According to an embodiment, the patterned protrusion layer is applied exclusively to the inner surface of the bottom wall.

In other words, while the patterned protrusion layer is applied to the inner surface of the bottom wall, it is preferably not applied to the inner surfaces of the side walls of the vessel.

On the one hand, it has been observed that it may be sufficient to apply the patterned protrusion layer only to the bottom wall in order to obtain the beneficial effect of the provided multiple nucleation points for the desired reduced dislocation density defect propagation. Applying the patterned protrusion layer also to the side walls of the vessel appears to not further improve physical characteristics of an ingot grown in such crucible. On the other hand, it appears that applying the patterned protrusion layer only on the inner surface of the bottom wall but not on the inner surfaces of the side walls may improve the crucibles characteristics during growing a silicon ingot. For example, non-wetting inner surfaces of side walls covered only by the coating layer but not by a patterned protrusion layer may simplify a release of a grown silicon ingot after solidification.

According to an embodiment, the nucleation enhancing material is adapted for forming a wetting agent when in contact with a liquid silicon melt.

In other words, the material used for the particles comprised in the patterned protrusion layer should be preferably selected such that a liquid silicon melt coming into contact with the protruding particles at the bottom of the crucible may wet these particles at least at their surface protruding beyond the matrix. Due to such wetting characteristics, the particles may serve as nucleation points thereby altering the surface morphology of the layer covering the inner surface at the bottom wall of the vessel.

According to the invention, the particles of the nucleation enhancing material are Silica sand (SiO2), Silicon carbide (SiC) or Carbon(C) particles. Silica sand (SiO2) may be the preferred option.

In other words, the particles consist of Silicon oxide or Silicon carbide or Carbon and may have typical dimensions and shapes like grains of sand. For example, the particles may have pointed tips, sharp edges or the like. Alternatively, the particles may be rounded or even sphere-like. Such sand particles have been observed to serve as nucleation points when locally protruding from a matrix consisting substantially of silicon nitride and coming into a contact with molten silicon to be solidified.

The particles of the nucleation enhancing material have sizes of between 100µm and 1mm. Such dimensions of the particles have been observed to result in a beneficial patterned protrusion layer as, inter alia, the particles may slightly protrude from a surrounding matrix by for example a few microns up to a few hundred microns but not extending too far into the inner portion of the vessel which might otherwise disturb a growth of a silicon ingot or even damage a superficial layer of the grown ingot.

It may be understood that the particles comprised in the patterned protrusion layer may be provided with a particle size distribution. This means that generally not all particles have same sizes but particle sizes may vary. Preferably, the particle size distribution is such that at least 50%, preferably at least 90% of all particles comprised in the patterned protrusion layer have sizes in a range of between 100µm and 1mm.

According to an embodiment, the patterned protrusion layer has a thickness of between 0.3mm and 3mm, preferably of between 1mm and 2mm.

Providing the patterned protrusion layer with such thickness has been observed to result in beneficial physical characteristics of ingots grown in such crucible.

It may be noted that the patterned protrusion layer may not have a uniform thickness. For example, the patterned protrusion layer may have a lower thickness in regions where there is only the matrix forming the patterned protrusion layer whereas it may have an extended thickness in regions where particles protrude from the matrix. Accordingly, the term "thickness of the patterned protrusion layer" may be understood herein as referring to an average thickness of the patterned protrusion layer. Furthermore, as the thickness of the patterned protrusion layer is mainly determined by the thickness with which the matrix is applied on top of the inner surface of the bottom wall, the thickness of the patterned protrusion layer roughly corresponds to the thickness of such matrix and may exceed the thickness of the matrix layer for example by not more than 30%, preferably not more than 10%. In other words, the particles locally protruding from the matrix may add to the average thickness of the patterned protrusion layer only by about 30%, preferably only about 10%, of the matrix layer thickness.

Particularly, selecting a beneficial size distribution of particles comprised in the patterned protrusion layer, on the one hand, and selecting a beneficial thickness of the patterned protrusion layer on the other hand, may influence a particle distribution within the patterned protrusion layer and/or a distance up to which the particles protrude from the matrix of the patterned protrusion layer.

For example, having large particles embedded in a very thin patterned protrusion layer would generally result in only few particles protruding into the inner portion of the vessel but these particles being relatively large and therefore protruding quite far into this inner portion. Such extreme configuration might not be optimum for the resulting physical characteristics of the grown silicon ingot.

In the other extreme, very small particles being comprised in a thick patterned protrusion layer might result in most of these particles being completely enclosed within the matrix instead of protruding therefrom. Accordingly, only few particles may serve as nucleation points.

Therefore, the size distribution of the particles embedded in the matrix, on the one hand, and the thickness of the patterned protrusion layer, on the other hand, should be suitably adapted with respect to each other.

Specifically, according to an embodiment, an amount of particles comprised in the patterned protrusion layer, a size distribution of these particles and/or a thickness of the patterned protrusion layer may be specifically selected such that the particles of the nucleation enhancing material protruding from the matrix are comprised in the patterned protrusion layer with an areal density of between 1 to 10/ cm², preferably of between 7 to 10 / cm².

Providing the particles in the patterned protrusion layer with such areal density has been observed to result in beneficial physical characteristics of silicon ingots grown in such crucible. Particularly, the areal density of protruding particles might influence a nucleation point density during solidifying the ingot and therefore might influence a dislocation defect density in the resulting ingot in a beneficial manner. For example, multiple nucleation points may increase the number of grains and subsequently may result in more random grain boundaries per unit volume. The higher is the grain boundary area per unit volume, the higher is generally the probability of dislocations stuck at grain boundaries since the misalignment between two adjacent grains cannot allow dislocation cross over the boundaries easily because of energy barrier. Higher concentration of dislocations can be accommodated in a unit volume of material. Therefore, more grain boundaries will generally slower a dislocation propagation.

Silica sand or Silicon carbide or Carbon particle size distribution should necessarily be controlled in order to make a stable slurry without any sedimentation, and to avoid higher interstitial oxygen content on wafer level. Smaller particles may lead to higher surface area and, during ingot process, may release more oxygen into the melt. Most of it is typically lost as SiO gas from molten surface but a rest may stay in the melt and may dissolve into crystalline silicon. Accordingly, it may be beneficial to control the particle size and/or particle size distribution.

According to an embodiment, the coating layer has a thickness of between 0.1mm and 1mm, preferably of between 0.4mm and 0.5mm.

A coating layer with such thickness may, on the one hand, be easily applied to inner surfaces of the vessel while, on the other hand, provide for sufficient protection and/or releasing characteristics.

According to an embodiment, the coating layer is applied using a specific slurry, called herein "first slurry", comprising at least silicon nitride powder. Furthermore, in a preferred implementation, the first slurry further comprises a binding agent, a dispersing agent and deionised water. Preferably, the first slurry does not comprise any further components or agents.

According to another embodiment, the patterned protrusion layer is applied using a second slurry comprising at least silicon nitride powder and particles of nucleation enhancing material. Furthermore, according to a preferred implementation, the second slurry further comprises a binding agent, a dispersing agent and deionised water. Again, preferably, the second slurry does not comprise any further components or agents.

Such first and/or second slurries may be easily applied to inner surfaces of walls of the vessel. Furthermore, such slurries may be applied with low efforts and/or at low costs. For example, the slurries may be sprayed on the inner surfaces. For example, a special dispensing spray system may be applied for spraying the slurries onto surfaces to be covered by a coating layer and/or a patterned protrusion layer, respectively. The coating of the inner surfaces may be done with elevated temperatures. Other techniques of applying the first and/or second slurry may be used alternatively. For example, a patterned mask as it is commonly used e.g in screen printing may be applied.

The silicon nitride powder comprised in the slurries may be a powder of small silicon nitride particles having typical sizes in a range of 0.1 µm to 5 µm. The silicon nitride powder may have a purity preferably exceeding 98%, more preferably exceeding 99.9%.

The binding agent may comprise polyvinyl alcohol or colloidal silica. Preferably, the binding agent may comprise colloidal silica and approximately 50% solid silica by weight with a particle size of 5 - 100 nanometers.

The dispersing agent may comprise propylene glycol.

It shall be noted, that the formulation indicating that "a layer is applied using a specific slurry" may be interpreted, on the one hand, as defining a specific characteristics of a manufacturing process for forming the respective layer or, on the other hand, may define structural features of the respective layer resulting from the specific manufacturing method. Expressed in more specific words, a coating layer applied using a first slurry or a patterned protrusion layer applied using a second slurry will generally have physical and/or structural properties which directly result from the fact that these layers are applied using a slurry, thereby differing for example from layers which are applied using other techniques such as CVD (Chemical Vapour Deposition) or PVD (Physical Vapour Deposition) techniques. For example, a coating layer or a patterned protrusion layer applied using specific slurries generally has a certain granular structure resulting from the fact that the slurry comprises more or less macroscopic powder particles whereas for example a layer applied using CVD or PVD techniques is typically more homogeneous resulting from the fact that it was built-up with much smaller microscopic particles such as atoms, molecules and/or clusters thereof. Furthermore, even though some components comprised in the slurry during its processing such as the binding agent, the dispersing agent and/or the deionised water may have disappeared during subsequent processing of the slurry and may therefore not be present within the final coating layer and/or patterned protrusion layer, the fact that these components or agents were part of the first and/or second slurry typically results in specific physical and/or structural characteristics of the resulting layers. For example, the resulting layers may have a typical porosity or morphology which is different from layers, particularly silicon nitride layers, applied using other techniques such as CVD or PVD.

According to an embodiment of the method defined as the second aspect of the invention, the first slurry for applying the coating layer has a lower viscosity than the second slurry used for depositing the patterned protrusion layer.

For example, the first slurry may have a viscosity of less than 100cP, preferably less than 10cP, whereas the second slurry may have a viscosity exceeding 100cP, preferably exceeding 500cP. Due to its low viscosity, the first slurry may be easily applied with a homogeneous thickness. The second slurry having the higher viscosity may be sprayed or cast and then optionally spread on the inner surface of the bottom wall of the vessel.

Patterned protrusion spots or a layer may be applied for example with the help of a mask, like screen printing, or with a special dispensing spray system. Therefore, a surface may have a hill (wetting) and valley (non-wetting) surface structure.

According to an embodiment, the first slurry has a lower density than the second slurry.

For example, the first slurry may have a density of less than 1.6g/cm³, preferably of less than 1.4g/cm³ whereas the second slurry may have a density of more than 1.6g/cm³, preferably of more than 1.9g/cm³.

The first slurry may be made with lower solid content to avoid e.g. clogging or blockage issues in automatic spray process. The second slurry may be made with higher solid content e.g. in order makes a stable slurry without any sedimentation and to enable printing protrusion spots.

It may be noted that possible features and/or benefits of embodiments of the present invention are described herein partly with respect to a crucible and partly with respect to a method for preparing a crucible. A person skilled in the art will understand that features described for embodiments of the crucible may be applied in analogy in an embodiment of the method according to the invention, and vice versa.

### BRIEF DESCRIPTION OF THE DRAWING

In the following, embodiments of the invention will be described herein with reference to the enclosed drawing. However, neither the drawing nor the description shall be interpreted as limiting the invention.

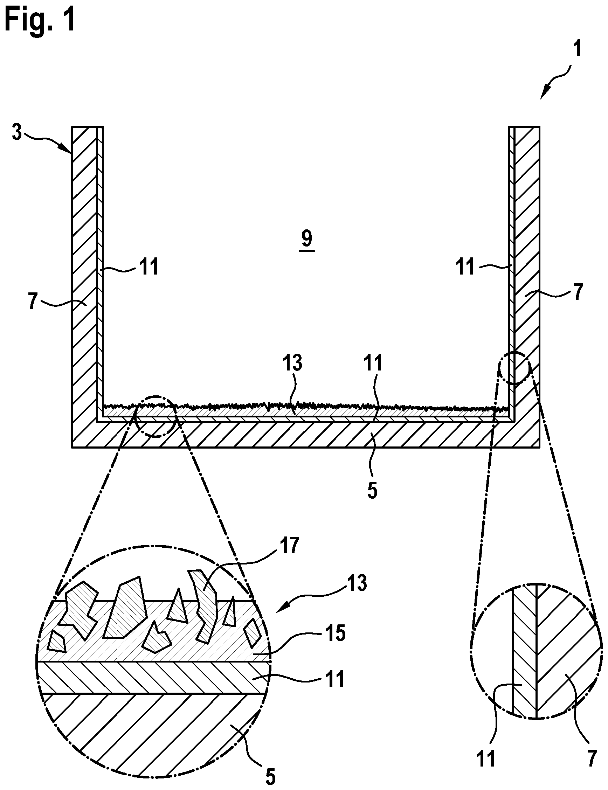

Fig. 1 shows a sectional view through a crucible according to an embodiment of the present invention.

The figure is only a schematic representation and not to scale.

### DESCRIPTION OF PREFERRED EMBODIMENTS

Fig. 1 shows a cross section through a crucible 1 according to an embodiment of the present invention. The crucible 1 is of a square type, i.e. has a box form or cuboid form. Other geometries are possible for the crucible.

The crucible 1 comprises a pot-like vessel 3 having a bottom wall 5 and side walls 7. The bottom wall 5 is generally rectangular and horizontal whereas the side walls 7 are rectangular and substantially vertical. The bottom wall 5 and the side walls 7 may form an integral component forming the entire vessel 3. Alternatively, the bottom wall 5 and the side walls 7 may be separate components and may be mounted together in order to form the entire vessel 3. The walls 5, 7 may be formed using sheet-like components. For example, the walls 5, 7 may be made with fused silica sheets. Typically, the bottom wall 5 is several tens of centimetres long and several tens of centimetres wide. The side walls 7 are typically several tens of centimetres high and several tens of centimetres wide. The bottom wall 5 and the side walls 7 typically have a thickness in a range of a few millimetres up to a few centimetres, for example between 3mm and 10cm.

The bottom wall 5 and the side walls 7 surround an inner portion 9 of the vessel 3. Therein, the vessel 3 is preferably open at its top.

Inner surfaces of the bottom wall 5 and the side walls 7 are coated with a thin coating layer 11. The coating layer 11 comprises or consists of silicon nitride as a temperature-resistant material. The coating layer 11 may therefore resist the very high temperatures of a silicon melt being cast into the vessel 3. Preferably, the coating layer 11 has a thickness of 400 to 500µm. Preferably, the coating layer 11 is substantially homogeneous, i.e. does not comprise macroscopic particles other than the silicon nitride powder particles used for forming the coating layer 11. Particularly, the coating layer 11 may have a macroscopically homogeneous thickness and may have a macroscopically smooth, preferably planar surface. The portions of the coating layer 11 covering the side walls 7 of the vessel 3 are preferably not covered by any other layer, i.e. are exposed towards the inner portion 9 of the vessel 3.

On the bottom wall 5, an additional layer is applied on top of the coating layer 11. This additional layer is a patterned protrusion layer 13 preferably covering the entire inner surface of the bottom wall 5. Accordingly, at the bottom wall 5, the coating layer 11 is not exposed but is covered by the overlying patterned protrusion layer 13.

As visible in the enlarged view of Fig. 1, the patterned protrusion layer 13 comprises a matrix 15 into which multiple particles 17 are embedded. Therein, the matrix 15 comprises silicon nitride as a temperature-resistant material. The particles 17 consist of a nucleation enhancing material such as silica. The particles 17 protrude beyond the upper exposed surface of the matrix 15. Thereby, the protruding particles 17 form a kind of pattern with nucleation enhancing tips protruding towards the inner portion 9 of the vessel 3.

The silica particles 17 may have typical sizes in a range of 100µm to 1mm. A pattern size, i.e. a lateral average distance between neighbouring protruding particles 17, may be in a typical range of 1 to 2mm. A protruding height of the particles 17 may be in a range from 1 to 2mm.

Finally, steps of a method for preparing or fabricating a crucible 1 are explained with respect to an exemplary embodiment.

In order to prepare or fabricate the crucible 1, first, a vessel 3 with a bottom wall 5 and side walls 7 is provided.

Then, a first silicon nitride coating slurry may be prepared by mixing high pure silicon nitride powder, deionised water, binding agent and dispersing agent. Such first slurry may then for example be sprayed or deposited in other ways such as screen printing on the inner surfaces of the bottom wall 5 and the side walls 7 of the square type fused silica crucible 1. Therein, the first slurry may be applied with a desired specified coating thickness of for example between 400 and 500 µm. The coating is typically done at elevated coating temperatures of between 40 and 50°C.

After the coating layer 11 has been applied in such manner, a second slurry is prepared with silicon nitride powder, deionised water, a binding agent and a wetting agent. Therein, the wetting agent may be formed by particles 17 made of a nucleation enhancing material such as silica sand particles. Preferably, this second slurry is applied only to the inner surface of the bottom wall 5 or of the coating layer 11 previously applied thereon.

While the first slurry has a relatively low density of for example 1.37g/cm³ and a low viscosity of for example 2.96cP, the second slurry has a higher density of for example 1.96g/cm³ and a higher viscosity of about 700cP.

After having applied the coating layer 11 and the patterned protrusion layer 13 onto the inner surfaces of the walls 5, 7 of the vessel 3, the coated crucible 1 is baked with high temperature and open atmospheric condition. At such conditions, the first and second slurries are solidified and form a dense coating layer 11 and patterned protrusion layer 13, respectively.

Silicon ingots grown with such crucible 1 may show reduced dislocation density defects. As a result thereof, solar cells produced with silicon wafers sliced from such ingots may have an improved conversion efficiency.

Finally, it should be noted that terms such as "comprising" do not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

- 1: crucible
- 3: vessel
- 5: bottom wall
- 7: side wall
- 9: inner portion
- 11: coating layer
- 13: patterned protrusion layer
- 15: matrix
- 17: particles

## Claims

1. Crucible (1) for growing silicon ingots, the crucible comprising:
a vessel (3) having a bottom wall (5) and side walls (7) surrounding an inner portion (9) of the vessel;
a coating layer (11) applied to inner surfaces of the bottom wall and the side walls, the coating layer comprising a temperature-resistant material compatible with ingot growth from molten silicon;
a patterned protrusion layer (13) applied to the inner surface of the coating layer (11) of the bottom wall, the patterned protrusion layer comprising:
a matrix (15) consisting of silicon nitride and adapted to form a non-wetting agent when in contact with the liquid silicon melt and further comprising
particles (17) of a nucleation enhancing material being one of Silica (SiO₂) sand, Silicon Carbide (SiC) and Carbon (C), which is adapted for forming a wetting agent when in contact with a liquid silicon melt such that a liquid silicon melt coming into contact with the particles may wet these particles,
the patterned protrusion layer (13) being applied in such manner and the particles (17) being adapted such that the particles locally protrude from the matrix (15)
the particles (17) of the nucleation enhancing material having sizes of between 100 µm and 1 mm.

2. The crucible of claim 1, wherein the patterned protrusion layer (13) is applied to the inner surface of the coating layer (11) of the bottom wall (5) exclusively.

3. The crucible of one of the preceding claims, wherein the patterned protrusion layer (13) has a thickness of between 0.3 mm and 3 mm, preferably of between 1 mm and 2 mm.

4. The crucible of one of the preceding claims, wherein the particles (17) of the nucleation enhancing material protruding from the matrix (15) are comprised in the patterned protrusion layer with an areal density of between 1 to 10 cm⁻², preferably of between 7 to 10 cm⁻².

5. The crucible of one of the preceding claims, wherein the coating layer (11) has a thickness of between 0.1 mm and 1 mm, preferably of between 0.4 mm and 0.5 mm.

6. The crucible of one of the preceding claims, wherein the temperature-resistant material comprised in the coating layer is silicon nitride.

7. The crucible of one of the preceding claims, wherein the coating layer (11) is applied using a first slurry comprising silicon nitride powder and, preferably, further comprising a binding agent, a dispersing agent and deionised water.

8. The crucible of one of the preceding claims, wherein the patterned protrusion (13) layer is applied using a second slurry comprising silicon nitride powder and particles of the nucleation enhancing material and, preferably, further comprising a binding agent, a dispersing agent and deionised water.

9. A method of preparing a crucible (1) for growing silicon ingots, the method comprising:
providing a vessel (3) having a bottom wall (5) and side walls (7) surrounding an inner portion (9) of the vessel; applying a coating layer (11) to inner surfaces of the bottom wall and the side walls, the coating layer comprising a temperature-resistant material compatible with ingot growth from molten silicon;
applying a patterned protrusion layer (13) to the inner surface of the coating layer (11) of the bottom wall, the patterned protrusion layer comprising a matrix (15) consisting of silicon nitride and adapted to form a non-wetting agent when in contact with the liquid silicon melt, and further comprising particles (17) of a nucleation enhancing material being one of Silica (SiOz) sand, Silicon Carbide (SiC) and Carbon (C) which is adapted for forming a wetting agent when in contact with a liquid silicon melt such that a liquid silicon melt coming into contact with the particles may wet these particles,
wherein the patterned protrusion layer (13) is applied in such manner and the particles (17) are adapted such that the particles locally protrude from the matrix (15), and
wherein the particles (17) of the nucleation enhancing material have sizes of between 100 µm and 1 mm.

10. The method of claim 9, wherein the coating layer (11) is applied using a first slurry comprising silicon nitride powder and the patterned protrusion layer (13) is applied using a second slurry comprising silicon nitride powder and particles (17) of the nucleation enhancing material.

11. The method of claim 10, wherein the first slurry has a lower viscosity than the second slurry.

12. The method of one of claims 10 to 11, wherein the first slurry has a lower density than the second slurry.

## Patentansprüche

1. Tiegel (1) zum Züchten von Silicium-Ingots, wobei der Tiegel Folgendes umfasst:
ein Gefäß (3) mit einer Bodenwand (5) und Seitenwänden (7), die einen Innenabschnitt (9) des Gefäßes umgeben;
eine Beschichtungsschicht (11), die auf Innenflächen der Bodenwand und der Seitenwände aufgebracht ist, wobei die Beschichtungsschicht ein temperaturbeständiges Material umfasst, das mit dem Züchten von ingots aus geschmolzenem Silicium kompatibel ist;
eine strukturierte Vorsprungsschicht (13), die auf die Innenfläche der Beschichtungsschicht (11) der Bodenwand aufgebracht ist, wobei die strukturierte Vorsprungsschicht Folgendes umfasst:
eine Matrix (15) aus Siliciumnitrid, die geeignet ist, ein Nichtbenetzungsmittel auszubilden, wenn sie mit der flüssigen Siliciumschmelze in Kontakt kommt, und weiters folgendes umfasst:
Teilchen (17) aus einem die Kristallisationskeimbildung fördernden Material, das eines aus Siliciumdioxid- (SiOz-) Sand, Siliciumcarbid (SiC) und Kohlenstoff (C) ist, das zur Ausbildung eines Benetzungsmittels geeignet ist, wenn es mit einer flüssigen Siliciumschmelze in Kontakt kommt, so dass eine flüssige Siliciumschmelze, die mit den Teilchen in Kontakt kommt, diese Teilchen benetzen kann;
wobei die strukturierte Vorsprungsschicht (13) derart aufgebracht ist und die Teilchen (17) dazu geeignet sind, dass die Teilchen lokal von der Matrix (15) wegstehen,
wobei die Teilchen (17) aus dem die Kristallisationskeimbildung fördernden Material eine Größe von 100 µm bis 1 mm aufweisen.

2. Tiegel nach Anspruch 1, wobei die strukturierte Vorsprungsschicht (13) ausschließlich auf der Innenfläche der Beschichtungsschicht (11) der Bodenwand (5) aufgebracht ist.

3. Tiegel nach einem der vorangegangenen Ansprüche, wobei die strukturierte Vorsprungsschicht (13) eine Dicke zwischen 0,3 mm und 3 mm, vorzugsweise zwischen 1 mm und 2 mm, aufweist.

4. Tiegel nach einem der vorangegangenen Ansprüche, wobei die Teilchen (17) aus dem die Kristallisationskeimbildung fördernden Material, die von der Matrix (15) wegstehen, in der strukturierten Vorsprungsschicht mit einer Flächendichte zwischen 1 und 10 cm⁻², vorzugsweise zwischen 7 und 10 cm⁻², enthalten sind.

5. Tiegel nach einem der vorangegangenen Ansprüche, wobei die Beschichtungsschicht (11) eine Dicke zwischen 0,1 mm und 1 mm, vorzugsweise zwischen 0,4 mm und 0,5 mm, aufweist.

6. Tiegel nach einem der vorangegangenen Ansprüche, wobei das in der Beschichtungsschicht enthaltene temperaturbeständige Material Siliciumnitrid ist.

7. Tiegel nach einem der vorangegangenen Ansprüche, wobei die Beschichtungsschicht (11) unter Verwendung einer ersten Aufschlämmung, die Siliciumnitrid-Pulver umfasst und vorzugsweise weiters ein Bindemittel, ein Dispergiermittel und entionisiertes Wasser umfasst, aufgebracht ist.

8. Tiegel nach einem der vorangegangenen Ansprüche, wobei die strukturierte Vorsprungsschicht (13) unter Verwendung einer zweiten Aufschlämmung, die Siliciumnitrid-Pulver und Teilchen aus dem die Kristallisationskeimbildung fördernden Material umfasst und vorzugsweise weiters ein Bindemittel, ein Dispergiermittel und entionisiertes Wasser umfasst, aufgebracht ist.

9. Verfahren zur Herstellung eines Tiegels (1) zum Züchten von Silicium-Ingots, wobei das Verfahren Folgendes umfasst:
das Bereitstellen eines Gefäßes (3) mit einer Bodenwand (5) und Seitenwänden (7), die einen Innenabschnitt (9) des Gefäßes umgeben; das Aufbringen einer Beschichtungsschicht (11) auf Innenflächen der Bodenwand und der Seitenwände, wobei die Beschichtungsschicht ein temperaturbeständiges Material umfasst, das mit dem Züchten von Ingots aus geschmolzenem Silicium kompatibel ist;
das Aufbringen einer strukturierten Vorsprungsschicht (13) auf die Innenfläche der Beschichtungsschicht (11) der Bodenwand, wobei die strukturierte Vorsprungsschicht eine Matrix (15) aus Siliciumnitrid umfasst, die geeignet ist, ein Nichtbenetzungsmittel auszubilden, wenn sie mit der flüssigen Siliciumschmelze in Kontakt kommt, und weiters Teilchen (17) aus einem die Kristallisationskeimbildung fördernden Material umfasst, das eines aus Siliciumdioxid- (SiOz-) Sand, Siliciumcarbid (SiC) und Kohlenstoff (C) ist, das zur Ausbildung eines Benetzungsmittels geeignet ist, wenn es mit einer flüssigen Siliciumschmelze in Kontakt kommt, so dass eine flüssige Siliciumschmelze, die mit den Teilchen in Kontakt kommt, diese Teilchen benetzen kann;
wobei die strukturierte Vorsprungsschicht (13) derart aufgebracht wird und die Teilchen (17) dazu geeignet sind, dass die Teilchen lokal von der Matrix (15) wegstehen,
wobei die Teilchen (17) aus dem die Kristallisationskeimbildung fördernden Material eine Größe zwischen 100 µm und 1 mm aufweisen.

10. Verfahren nach Anspruch 9, wobei die Beschichtungsschicht (11) unter Verwendung einer ersten Aufschlämmung, die Siliciumnitrid-Pulver umfasst, aufgebracht wird und die strukturierte Vorsprungsschicht (13) unter Verwendung einer zweiten Aufschlämmung, die Siliciumnitrid-Pulver und Teilchen (17) aus dem die Kristallisationskeimbildung fördernden Material umfasst, aufgebracht wird.

11. Verfahren nach Anspruch 10, wobei die erste Aufschlämmung eine niedrigere Viskosität als die zweite Aufschlämmung aufweist.

12. Verfahren nach einem der Ansprüche 10 bis 11, wobei die erste Aufschlämmung eine geringere Dichte als die zweite Aufschlämmung aufweist.

## Revendications

1. Creuset (1) pour la croissance de lingots de silicium, le creuset comprenant :
un bac (3) présentant une paroi de fond (5) et des parois latérales (7) entourant une partie intérieure (9) du bac ;
une couche de revêtement (11) appliquée sur des surfaces intérieures de la paroi de fond et des parois latérales, la couche de revêtement comprenant un matériau résistant à la température compatible avec une croissance de lingots à partir de silicium fondu ;
une couche de saillies à motif (13) appliquée sur la surface intérieure de la couche de revêtement (11) de la paroi de fond, la couche de saillies à motif comprenant :
une matrice (15) constituée de nitrure de silicium et adaptée pour former un agent non mouillant lorsqu'elle est en contact avec la coulée de silicium liquide et comprenant en outre
des particules (17) d'un matériau d'amélioration de nucléation qui est l'un parmi du sable de silice (SiO₂), du carbure de silicium (SiC) et du carbone (C), qui est adapté pour former un agent mouillant lorsqu'il est en contact avec une coulée de silicium liquide de telle sorte qu'une coulée de silicium liquide entrant en contact avec les particules peut mouiller ces particules,
la couche de saillies à motif (13) étant appliquée de telle sorte et les particules (17) étant adaptées de telle sorte que les particules font localement saillie depuis la matrice (15)
les particules (17) du matériau d'amélioration de nucléation présentant des tailles comprises entre 100 µm et 1 mm.

2. Creuset selon la revendication 1, dans lequel la couche de saillies à motif (13) est appliquée exclusivement sur la surface intérieure de la couche de revêtement (11) de la paroi de fond (5).

3. Creuset selon l'une quelconque des revendications précédentes, dans lequel la couche de saillies à motif (13) présente une épaisseur comprise entre 0,3 mm et 3 mm, de préférence entre 1 mm et 2 mm.

4. Creuset selon l'une des revendications précédentes, dans lequel les particules (17) du matériau d'amélioration de nucléation faisant saillie depuis la matrice (15) sont comprises dans la couche de saillies à motif avec une densité surfacique comprise entre 1 et 10 cm⁻², de préférence entre 7 et 10 cm⁻².

5. Creuset selon l'une des revendications précédentes, dans lequel la couche de revêtement (11) présente une épaisseur comprise entre 0,1 mm et 1 mm, de préférence entre 0,4 mm et 0,5 mm.

6. Creuset selon l'une des revendications précédentes, dans lequel le matériau résistant à la température compris dans la couche de revêtement est du nitrure de silicium.

7. Creuset selon l'une quelconque des revendications précédentes, dans lequel la couche de revêtement (11) est appliquée en utilisant une première suspension comprenant de la poudre de nitrure de silicium et, de préférence, comprenant en outre un agent de liaison, un agent de dispersion et de l'eau désionisée.

8. Creuset selon l'une quelconque des revendications précédentes, dans lequel la couche de saillies à motif (13) est appliquée en utilisant une seconde suspension comprenant de la poudre de nitrure de silicium et des particules du matériau d'amélioration de nucléation et, de préférence, comprenant en outre un agent de liaison, un agent de dispersion et de l'eau désionisée.

9. Procédé de préparation d'un creuset (1) pour la croissance de lingots de silicium, le procédé comprenant les étapes consistant à :
fournir un bac (3) présentant une paroi de fond (5) et des parois latérales (7) entourant une partie intérieure (9) du bac ; appliquer une couche de revêtement (11) sur des surfaces intérieures de la paroi de fond et des parois latérales, la couche de revêtement comprenant un matériau résistant à la température compatible avec une croissance de lingots à partir de silicium fondu ;
appliquer une couche de saillies à motif (13) sur la surface intérieure de la couche de revêtement (11) de la paroi de fond, la couche de saillies à motif comprenant une matrice (15) constituée de nitrure de silicium et adaptée pour former un agent non mouillant lorsqu'elle est en contact avec la coulée de silicium liquide, et comprenant en outre des particules (17) d'un matériau d'amélioration de nucléation qui est l'un parmi du sable de silice (SiO₂), du carbure de silicium (SiC) et du carbone (C) qui est adapté pour former un agent mouillant lorsqu'il est en contact avec une coulée de silicium liquide de telle sorte qu'une coulée de silicium liquide entrant en contact avec les particules peut mouiller ces particules,
dans lequel la couche de saillies à motif (13) est appliquée de telle sorte et les particules (17) sont adaptées de telle sorte que les particules font saillie localement depuis la matrice (15), et
dans lequel les particules (17) du matériau d'amélioration de nucléation ont des tailles comprises entre 100 µm et 1 mm.

10. Procédé selon la revendication 9, dans lequel la couche de revêtement (11) est appliquée en utilisant une première suspension comprenant de la poudre de nitrure de silicium et la couche de saillies à motif (13) est appliquée en utilisant une seconde suspension comprenant de la poudre de nitrure de silicium et des particules (17) du matériau d'amélioration de nucléation.

11. Procédé selon la revendication 10, dans lequel la première suspension a une viscosité inférieure à celle de la seconde suspension.

12. Procédé selon l'une des revendications 10 à 11, dans lequel la première suspension a une densité inférieure à celle de la seconde suspension.
